# EUROPÄISCHE PATENTSCHRIFT

(11) **EP 3 797 303 B1**
(45) Veröffentlichungstag und Bekanntmachung des Hinweises auf die Patenterteilung: **24.01.2024**
(21) Anmeldenummer: 19739203.8
(22) Anmeldetag: 20.06.2019
(51) Int. Cl.: G01R 15/18

(54) **ANORDNUNG AUFWEISEND EINEN GEWENDELTEN LEITERSTRANG**
ARRANGEMENT HAVING A SPIRALLED CONDUCTOR STRAND
DISPOSITIF COMPRENANT UNE CORDE CONDUCTRICE HÉLICOÏDALE

(30) Priorität: 20.07.2018 DE 102018212144
(43) Veröffentlichungstag der Anmeldung: 31.03.2021
(73) Patentinhaber: Siemens Energy Global GmbH & Co. KG, 81739 München (DE)
(72) Erfinder: BEUTEL, Stefan, 10555 Berlin (DE); HOLTZ, Benjamin, 13599 Berlin (DE); OLSZEWSKI, Wojciech, 13629 Berlin (DE)
(86) Internationale Anmeldenummer: PCT/EP2019/066315
(87) Internationale Veröffentlichungsnummer: WO 2020/015949

(56) Entgegenhaltungen:
- EP-A1- 3 241 513
- EP-A2- 2 275 827
- WO-A1-01/22100
- WO-A1-2013/186420
- DE-C1- 3 708 731
- US-A- 3 626 291
- US-A- 3 974 440
- US-A- 6 114 847
- US-A1- 2013 063 125
- US-B1- 6 300 857

## Beschreibung

Die Erfindung betrifft eine Anordnung aufweisend einen gewendelten Leiterstrang, welcher von einem Wickelträger getragen ist und der Wickelträger ein Ring aus mehreren aneinander stoßenden Segmenten ist, wobei an zumindest einem ersten Stoß der gewendelte Leiterstrang beiderseits des Stoßes unter Freilassung desselben endet und an einem zweiten Stoß der Leiterstrang über den zweiten Stoß hinweg verläuft.

Ein derartiger gewendelter Leiterstrang ist beispielsweise der Patentschrift DE 37 08 731 C1 entnehmbar. Dort ist eine bifilar gewickelte Rogowskispule mit Mittelanzapfung beschrieben, welche auf einen Wickelträger aufgebracht ist. Der dortige Wickelträger ist zweigeteilt ausgeführt, wodurch eine Bewegbarkeit des Wickelträgers mit dem darauf angeordneten gewendelten Leiterstrang ermöglicht ist. Nachteilig ist, dass bei einer Bewegung stets derselbe Abschnitt des gewendelten Leiterstranges einer Umformung unterworfen wird. Weiterhin sind die vorgesehenen Leiterenden des Leiterstranges über eine lösbare Verbindung zu kontaktieren, so dass ein Aufklappen und Überstreifen des Wickelkörpers nebst gewendeltem Leiterstrang ermöglicht ist. Die bekannte Anordnung weist den Nachteil auf, dass zum einen bei einer Bewegung stets die gleichen Abschnitte des Leiterstranges mechanischer Belastung unterworfen werden, wodurch einerseits ein frühzeitiges Altern erwartet werden kann, andererseits wird durch diese Bewegung die Lage des Leiterstranges verschoben, wodurch die Exaktheit des gewendelten Leiterstranges beeinflusst wird. Weiterhin ist nachteilig, dass bei einem Öffnen ein Auflösen bzw. ein Verbinden des Leiterstranges notwendig ist.

Aus den US Patenten US 6,114,847, US 3,626,291, US 6,300,857, US 3,974,440, der US Patentanmeldung n US 2013/0063125, sowie der europäischen Patentanmeldung EP 3 241 513 sind Sensoren bekannt welche unter Nutzung von Wicklungen einer Erfassung eines elektrischen Stromes dienen. Aus den internationalen Veröffentlichungen WO 01/22100 sowie WO 2013/186420 und der europäischen Patentanmeldung EP 2 275 827 ist die Verwendung von Rogowskispulen für die Messung eines Stromes beschrieben.

Somit ergibt sich als Aufgabe der Erfindung, eine Anordnung anzugeben, welche bei vereinfachten Gestehungskosten einen langzeitstabilen gewendelten Leiterstrang zur Verfügung stellt.

Erfindungsgemäß wird die Aufgabe bei einer eingangs genannten Anordnung dadurch gelöst, dass der Wickelträger nebst Leiterstrang in einem Isolierkörper vergossen ist.

Ein Wickelträger dient als Basis zur Aufnahme eines gewendelten Leiterstranges. Der Leiterstrang ist bevorzugt elektrisch isoliert ausgebildet und in Form einer Wendel (Helix) um den Wickelträger herumgelegt. Dadurch entsteht ein Leiterstrang mit einer Vielzahl von Schlaufen, wodurch eine so genannte Rogowskispule gebildet werden kann. Die Schlaufen sind von dem Wickelträger durchsetzt. Der Wickelträger kann aus mehreren aneinander stoßenden Segmenten gebildet sein, so dass ein in sich geschlossener Ring entsteht, auf welchem der gewendelte Leiterstrang sich insbesondere gleichmäßig verteilt erstreckt. Durch die Anordnung des Leiterstranges auf dem Wickelträger kann einerseits eine einfache Herstellung erfolgen, andererseits ist die Stabilisierung des Leiterstranges durch den Wickelträger selbst gegeben, so dass eine Umformung bzw. Verformung des gewendelten Leiterstranges erschwert ist. Entsprechend ist es vorteilhaft, dass an einem ersten Stoß der Leiterstrang beiderseits des Stoßes unter Freilassung desselben endet und an einem zweiten Stoß der Leiterstrang über den Stoß hinweg verläuft. Somit ist im Verlauf des geschlossenen Ringes an einer Stoßstelle in einfacher Form eine Möglichkeit gegeben, die Stoßstelle zu öffnen, ohne dabei den Leiterstrang aufzutrennen oder verbinden zu müssen. Eine elektrische Kontaktierung des Leiterstranges kann so dauerhaft vorgenommen werden. Dabei kann ausgehend von dem Stoß, an welchem der Leiterstrang eine elektrische Überbrückung vornimmt, beiderseits des Stoßes ein Wickeln des Leiterstranges zu dem frei gelassenen Stoß erfolgen, so dass ein gewendelter Leiterstrang mit Schlitz im Ringverlauf des Wickelträgers entsteht. Somit besteht die Möglichkeit, eine Mittelanzapfung des Leiterstranges insbesondere an dem Stoß vorzusehen, an welchem eine elektrische Brückung erfolgt. Am ersten Stoß kann der Leiterstrang sich auf den beiderseits des Sto-ßes befindlichen Segmenten dem ersten Stoß nähern. Mit Erreichen des Stoßes kann jeweils ein Wendepunkt im Verlauf des Leiterstranges erfolgen und eine Rückführung zu dem zweiten Stoß vorgesehen sein. Dazu kann der Leiterstrang in Teilstränge unterteilt sein, welche gemeinsam den Leiterstrang bilden.

Vorteilhafterweise kann dabei vorgesehen sein, dass der gewendelte Leiterstrang aus mehreren Teilsträngen zusammengesetzt ist.

Der gewendelte Leiterstrang kann aus mehreren Teilsträngen zusammengesetzt sein. Dabei kann vorgesehen sein, dass zur elektrischen Kontaktierung zweier Teilstränge eine Verbindung der Teilstränge im Bereich eines Stoßes zweier Segmente erfolgt. Der Leiterstrang kann einen Stoß elektrisch leitend überbrücken, indem Teilstränge miteinander elektrisch leitend kontaktiert werden. Vorteilhafterweise kann an demselben Stoß, an welchem Teilstränge miteinander kontaktiert sind, eine Ausleitung der verbleibenden Wickelenden (Mittelanzapfung) der Teilstränge vorgenommen werden, so dass an einer Position im Umlauf des Wickelträgers eine Kontaktierung der Teilstränge untereinander vorgenommen werden kann und auch die Enden des Leiterstranges für einen Anschluss des zusammengesetzten Leiterstranges beispielsweise an eine Messvorrichtung herausgeführt werden können.

Vorteilhafterweise kann vorgesehen sein, dass zumindest ein Segment von aneinander stoßenden Segmenten einen radial vorspringenden Anschlag aufweist, welcher ein endseitiges Abrutschen des Leiterstranges verhindert.

Ein vorspringender Anschlag kann beispielsweise ein endseitig an einem Segment angeordneter Bund sein, der etwa lotrecht um einen Querschnitt des Wickelträgers herum umläuft. Dadurch ist ein Anschlag gebildet, gegen welchen ein Leiterstrang gewickelt werden kann, so dass ein Wickelende des Leiterstranges endseitig fixiert werden kann. Vorteilhafterweise ist der Anschlag dabei in radialer Richtung bezüglich der Toroidachse mit einer Höhe gegenüber der Wickelfläche des Wickelträgers versehen, welcher etwa dem Querschnitt des Leiterstranges entspricht. Entsprechend kann ein bündiges, nahezu vorsprungsfreies Anlegen des Leiterstranges am Anschlag vorgenommen werden. Bevorzugt kann ein Wendepunkt in der Wickelrichtung des Leiterstranges, insbesondere eines Teilstranges am Anschlag liegend/anstoßend vorgesehen sein. Der Anschlag kann auch genutzt werden, um einen Stoß zwischen Segmenten zu begrenzen.

Es ist vorgesehen, dass der Wickelträger nebst Leiterstrang in einem Isolierkörper vergossen ist.

Ein Verguss des Wickelträgers nebst Leiterstrang in einem Isolierkörper weist den Vorteil auf, dass sowohl der Wickelkörper als auch der Leiterstrang selbst relativ zueinander fixiert werden können. Des Weiteren kann auch bei einer segmentartigen Unterteilung des Wickelträgers die Position der Segmente zueinander durch einen Verguss gesichert werden. Somit ist es beispielsweise möglich, gleichartig gewickelte Teilstränge auf jeweils gleichartigen Segmenten anzuordnen und durch ein Zusammenfügen der gleichartigen Segmente einen geschlossenen Umlauf des gewendelten Leiterstranges auf einer Ringbahn zu erzielen. Vorteilhafterweise kann dabei vorgesehen sein, dass an dem jeweiligen Segment, an einem Segmentende die freien Enden eines Teilstranges eines Leiterstranges liegen, und das andere Segmentende freigehalten von den freien Enden des jeweiligen Teilstranges des Leiterstranges ist. Dort kann bevorzugt ein Wendepunkt im Wickelsinne eines Teilstranges angeordnet sein. Entsprechend können insbesondere bei einer zweiteiligen Ausführung eines Wickelträgers Fehlmontagen verhindert werden, da jeweils die gleichartig ausgeführten Enden der Segmente bezüglich der Lage der freien Enden der Teilstränge des Leiterstranges unter Bildung eines Stoßes einander zugewandt werden können.

Durch die Verwendung eines Vergusses in einem Isolierkörper ist es möglich, die Anordnung als Messwandler zu verwenden, wobei der Isolierkörper von einem elektrischen Leiter durchsetzt sein kann. Der elektrische Leiter kann dabei einem Stromfluss unterworfen werden, so dass in dem gewendelten Leiterstrang eine proportionale physikalische Größe zum Stromfluss abgebildet wird. Der Isolierkörper kann als fluiddichte Barriere eingesetzt werden.

Bedarfsweise kann der Isolierkörper und/oder der elektrische Leiter einen Überströmkanal aufweisen, so dass ein Durchtritt eines Fluids, insbesondere eines Isoliergases, ermöglicht ist.

Weiter kann vorteilhaft vorgesehen sein, dass der Leiterstrang, insbesondere ein Teilstrang auf ein Segment gewickelt ist, wobei umgriffen von der gebildeten Helix eine Rückführung eines Wickelendes des Leiterstranges bzw. Wickelendes des Teilstranges, innerhalb der Helix erfolgt.

Zur Ausbildung einer Helix kann ein Leiterstrang, insbesondere ein Teilstrang auf ein Segment gewickelt werden. Dabei wird vorteilhaft an einem Segmentende mit dem Aufwickeln des Leiterstranges bzw. Teilstranges auf das Segment begonnen und dieses bis zum anderen Ende des Segmentes fortgeführt. Entsprechend entsteht eine links- bzw. rechtsgängige Helix, die sich von dem einen Segmentende zu dem anderen Segmentende erstreckt. Vorteilhaft kann umgriffen von der so gebildeten Helix eine Rückführung eines Wickelendes eines Leiterstranges bzw. eines Wickelendes des Teilstranges innerhalb der Helix erfolgen, so dass umgriffen von der Helix im dort geschirmten Bereich der Teilstrang verlaufen kann. Dabei kann vorgesehen sein, dass die Rückführung des Teilstranges ebenfalls in einer Helix, bevorzugt in einer Helix mit entgegengesetztem Wickelsinn bezüglich der umgreifenden Helix erfolgt. Es kann jedoch auch vorgesehen sein, dass einfach dem Verlauf des Segmentes folgend ein gekrümmter oder linearer Verlauf (frei von Wendelschlaufen) des rückgeführten Abschnittes des Teilstranges bzw. des Leiterstranges dem Verlauf des Segmentes folgend erfolgt. Entsprechend können an einem Segmentende die endseitigen Enden (Wickelenden) des Leiterstranges bzw. des Teilstranges zur Lage kommen und können dort weiter elektrisch kontaktiert bzw. verbunden werden. Das andere Segmentende kann so bevorzugt von endseitigen Enden des Leiterstranges bzw. des Teilstranges freigehalten (Wickelenden) werden. An diesem anderen Ende kann ein Wendepunkt im Verlauf des Leiterstranges / des Teilstranges angeordnet sein. Bedarfsweise kann jedoch auch vorgesehen sein, dass eine Mittelanzapfung des Teilstranges bzw. des Leiterstranges vorgesehen ist, wodurch beispielsweise ausgehend von einem zentralen Bereich des Segmentes jeweils zu den Enden des Segmentes ein Wickeln einer Helix vorgesehen ist, wobei im Inneren der sich so einstellenden Helix eine Rückführung der Leiterenden (Wickelenden) zu dem zentralen Bereich des Segmentes erfolgt.

Eine weitere vorteilhafte Ausgestaltung kann vorsehen, dass der Leiterstrang, insbesondere ein Teilstrang derart auf ein Segment gewickelt ist, dass zunächst eine linksgängige Helix gewickelt und mit Erreichen eines Endes eines Segmentes eine rechtsgängige Helix in zwischen den Helixschlaufen der linksgängigen Helix befindliche Freiräume oder umgekehrt unter jeweiligem Kreuzen der beiden Helices eingelegt ist.

Wirkungsgleich kann zunächst eine rechtsgängige und anschließend eine linksgängige Helix gewickelt werden. Ein Teilstrang eines Leiterstranges kann zunächst auf ein Segment gewickelt werden, wobei zunächst eine linksgängige Helix gewickelt wird. Mit Erreichen des Endes eines Segmentes wird dann eine rechtsgängige Helix in die Zwischenräume der Helixschlaufen der linksgängigen Helix eingelegt. Zwischen rechtsgängiger und linksgängiger Helix ist ein Wendepunkt im Verlauf des Teilstranges bzw. des Leiterstranges angeordnet. Dadurch wird ein bündiger Verbund zwischen links und rechtsgängiger Helix im Verlauf des Segmentes des Wickelträgers erzielt, wobei der Anfang des Wickels und das Ende des Wickels (freie Enden, Wickelenden) an ein und demselben Ende des Segmentes zum Liegen kommen. Am anderen entgegengesetzten Ende des Segmentes ist lediglich ein Wendepunkt des Teilstranges bzw. des Leiterstranges angeordnet. Dabei sollte vorteilhaft vorgesehen sein, dass zwischen, insbesondere zwischen jeder links- bzw. rechtsgängigen Leiterschlaufe, die wechselweise im Verlauf des Segmentes insbesondere benachbart liegen, eine Kreuzung der beiden Helices erfolgt. Die Kreuzungspunkte der beiden Helices sollten dabei bevorzugt in axialer Richtung bezüglich der Ringachse des Wickelträgers liegen. Somit sind Innenmantel und Außenmantel, also Innendurchmesser und Außendurchmesser eines Ringes, frei von Überkreuzungen. Dort liegt eine annähernd parallele Anordnung der jeweiligen Leiterschlaufen der Helices vor. Vorteilhaft kann vorgesehen sein, dass der Wickelträger mit einem kreisrunden Querschnitt ausgestattet ist. Es kann jedoch auch vorgesehen sein, dass darüber hinaus beispielsweise rechteckige Querschnitte, polygonale Querschnitte, ovale Querschnitte usw. für den Wickelträger vorgesehen sind. Insbesondere die Verwendung eines rechteckigen Querschnitts ermöglicht es, bei der Nutzung mehrerer Wickelträger, die koaxial angeordnet sind, diese möglichst eng aneinander zu legen.

Vorteilhafterweise kann weiter vorgesehen sein, dass der Wickelträger einen Wärmeausdehnungskoeffizienten aufweist, der kleiner oder gleich dem Wärmeausdehnungskoeffizienten des Isolierkörpers ist.

Bei Verwendung gleicher Wärmeausdehnungskoeffizienten für den Wickelträger und den Isolierkörper ist die Gefahr des Auftretens von Wärmespannungen reduziert. Dabei kann der Wärmeausdehnungskoeffizient des Wicklungsträgers kleiner sein als der Wärmeausdehnungskoeffizient des Isolierkörpers.

Der Wickelträger und der Isolierkörper, in welchen der Wickelträger sowie der Leiterstrang eingegossen sind, sind bevorzugt aus dem gleichen Material, d. h. aus dem gleichen elektrisch isolierenden Material gebildet. Als geeignet haben sich beispielsweise Kunststoffe, insbesondere organische Kunststoffe wie Harze oder ähnliches erwiesen. Durch die Verwendung gleichartiger Materialien für die Isolierkörper können sich insbesondere beim Auftreten von Wärmespannungen innerhalb des vergossenen Körpers gleichartige Relativbewegungen ergeben, so dass einem Reißen bzw. Zersplittern des nachträglich vergossenen Wickelträgers entgegengewirkt ist.

Eine weitere vorteilhafte Ausgestaltung kann vorsehen, dass jedes der Segmente gleichartig aufgebaut ist und jeweils einen gleichartigen Teilstrang des Leiterstranges trägt.

Durch die Verwendung gleichartiger Segmente und gleichartiger, insbesondere gleichartig gewickelter Teilstränge des Leiterstranges auf dem jeweils gleichartigen Segment kann aus ein und derselben Art von Segmenten nebst Teilstrang eine Anordnung aus mehreren Gleichteilen zusammengesetzt werden. Besonders vorteilhaft kann dabei vorgesehen sein, dass die Wicklung eines Teilstranges auf dem jeweiligen Segment derart erfolgt, dass an einem Ende des Segmentes beginnend, zunächst eine linksgängige Helix gewickelt wird und angelangt am anderen Ende des Segmentes ein Wendepunkt im Teilstrang des Leiterstranges angeordnet wird, worauf folgend eine rechtsgängige Helix in die Zwischenräume der bereits aufgewickelten linksgängigen Helix eingelegt wird. Entsprechend erfolgt dabei ein Kreuzen von links- und rechtsgängiger Helix zwischen jeder der links- bzw. rechtsgängigen Wendelschlaufen. Ein gleichartiges Ergebnis wird erzielt, sofern zunächst eine rechtsgängige Helix gewickelt wird, in welche eine linksgängige Helix eingelegt wird.

Entsprechende Segmente mit aufgewickelten Teilsträngen weisen jeweils nur an einem Ende die endseitigen Anschlussstellen (Enden) der Teilstränge auf, während am anderen Ende lediglich ein Wendepunkt des Teilstranges liegt. Somit können jeweils gleichartige Enden von gewickelten Segmenten einander zugewandt werden, wodurch eine Fehlmontage verhindert ist.

Eine weitere Ausgestaltung kann vorsehen, dass jeweils endseitige Enden zweier Teilstränge an aneinanderstoßenden Segmenten miteinander kontaktiert sind, während die jeweils anderen Enden der Teilstränge einem Abgriff eines Messsignals insbesondere am selben Stoß dienen.

An den endseitigen Enden (Wickelenden) zweier Teilstränge und an einem dort liegenden Stoß zwischen den Segmenten kann eine elektrische Kontaktierung von ersten Enden der Teilstränge miteinander vorgenommen werden, wobei die zweiten Enden der Teilstränge auf dem jeweiligen Segment einem Abgriff des Messsignales dienen. So wird durch die Kontaktierung eines ersten Endes der Teilstränge aus den beiden Teilsträngen ein elektrisch verbundener gewendelter Leiterstrang gebildet, dessen verbleibende freie Enden an ein und demselben Stoß im Verlauf des Wickelträgers nach außen geführt sind. Entsprechend ist ein gewendelter Leiterstrang mit Mittelabgriff gebildet. Ein anderer Stoß, insbesondere an einem diametral gegenüberliegend angeordneten Stoß bei kreisringförmiger zweiteiliger Ausbildung des Wickelträgers, kann so frei von einem Überspringen bzw. Überdecken durch den gewendelten Leiterstrang gehalten werden.

Eine weitere vorteilhafte Ausgestaltung kann vorsehen, dass zwei ringförmige Wickelträger koaxial zueinander angeordnet sind und vor einem Verguss in einem Isolierkörper ein Abstandhalter zwischen den Wickelkörpern angeordnet ist, wobei der Abstandhalter im Wesentlichen radial ausgerichtete Kanäle aufweist. Durch den Abstandhalter kann bei koaxialer Anordnung ein axialer Versatz der Wickelträger festgelegt werden. Die Nutzung zweier ringförmiger Wickelkörper und eine koaxiale Anordnung derselben ermöglicht es, eine Redundanz der Wickelkörper zu erzielen. Die Wickelkörper können axial versetzt zueinander angeordnet sein. Durch einen gleichartigen Aufbau der Wickelkörper nebst gleichartig gewendelten Leitersträngen kann so ein möglichst gleichartiges Signal von jedem der Leiterstränge auf dem jeweiligen Wickelträger abgegriffen werden. Vorteilhafterweise kann zwischen den beiden Wickelträgern nebst darauf befindlichem Leiterstrang ein Abstandhalter zwischen den Wickelkörpern angeordnet werden, so dass eine bevorzugt koaxiale Ausrichtung der Wickelkörper erzwungen wird. Der Abstandhalter weist dabei bevorzugt radial ausgerichtete Kanäle auf, um bei einem Verguss mit einem elektrisch isolierenden Material zur Ausbildung eines Isolierkörpers das Vergussmaterial vollumfänglich zu allen Bereichen der ringförmigen Wickelträger zu transportieren. Dabei können die ringförmigen Wickelträger auf einer Ringelektrode aufsitzen, welche insbesondere einer Spannungsmessung an einem von den ringförmigen Wickelkörpern zu umgreifenden Phasenleiter ermöglicht.

Eine weitere Aufgabe ist es, die Anordnung gemäß einem der Patentansprüche in einer Elektroenergieübertragungseinrichtung, insbesondere in einer Elektroenergieübertragungseinrichtung mit Druckgasisolation zu verwenden.

Die Aufgabe wird gelöst durch die Bildung eines Messwandlers, welcher in einer druckfluidisolierten Elektroenergieübertragungseinrichtung angeordnet ist.

Eine Elektroenergieübertragungseinrichtung mit Druckgasisolation weist im Regelfall Behälter zur Begrenzung der Druckgasisolation auf, wobei ein Phasenleiter elektrisch isoliert gegenüber dem Behälter abzustützen ist. Eine derartige elektrische Isolation kann beispielsweise mittels einer gemäß vorstehenden Patentansprüchen ausgebildeten Anordnung erzielt werden. Beispielsweise kann eine mit einem elektrischen Isoliermaterial vergossene Anordnung eine Flanschöffnung verschließen und so ein elektrisch isolierendes Gas im Inneren des Behälters der druckgasisolierten Elektroenergieübertragungseinrichtung einschließen.

Weiter wird ein Verfahren zum Herstellen eines Messwandlers beschrieben, der einen Wickelträger in Form eines Isolierringes aufweist, auf welchem ein Leiterstrang in Form einer gewendelten Helix aufgewickelt ist.

Bei einem Verfahren der vorstehend genannten Art wird zunächst eine erste Helix auf ein erstes Segment und eine zweite Helix auf ein zweites Segment aufgewickelt, die Segmente zu einem Ring in einem Felgenbett einer Ringelektrode zusammengefügt und sowohl die Ringsegmente nebst Helices als auch die Ringelektrode in ein Isoliermaterial eingegossen.

Eine Anordnung einer ersten Helix auf einem ersten Segment und eine Anordnung einer zweiten Helix auf einem zweiten Segment ermöglicht es in einfacher Form, eine Ringelektrode zu umgreifen, indem das erste Segment und das zweite Segment aus radialer Richtung auf den Ring aufgesetzt werden. Durch die Nutzung einer Ringelektrode mit einem Felgenbett ist so einerseits eine radiale aber auch eine axiale Ausrichtung des ersten Segmentes sowie des zweiten Segmentes ermöglicht. Nach einem erfolgten Ausrichten der Ringsegmente zueinander erfolgt anschließend ein Vergießen der Ringsegmente sowie der darauf angeordneten Helices nebst der Ringelektrode mit Isoliermaterial, so dass ein kompakter Block entsteht, in welchem sowohl der Isolierring als auch die Ringelektrode vollständig eingebettet (ummantelt) sind. Die Anschlussleitungen der Helix können durch das Isoliermaterial hindurch nach au-ßen geführt werden. Die Ringelektrode kann dabei beispielsweise über eine Ausnehmung in dem zu vergießenden Isoliermaterial von einem Phasenleiter gequert werden, welcher, getrieben durch eine Spannung, einen elektrischen Strom führt. Über die Segmente kann der elektrische Strom mittels des gewendelten Leiterstranges abgebildet werden, wohingegen die treibende Spannung über eine Aufladung der Elektrode abgebildet werden kann.

Im Folgenden wird ein Ausführungsbeispiel der Erfindung schematisch in einer Zeichnung gezeigt und nachfolgend näher beschrieben. Dabei zeigt die
- Figur 1:: einen Querschnitt durch eine gasisolierte Elektroenergieübertragungseinrichtung; die
- Figur 2:: eine Draufsicht auf einen Wickelträger nebst gewendeltem Leiterstrang; die
- Figur 3:: einen Wickelträger mit rechteckigem Querschnitt nebst gewendeltem Leiterstrang; die
- Figur 4:: ein Detail des aus der Figur 3 bekannten Wickelträgers nebst gewendeltem Leiterstrang; die
- Figur 5:: ein weiteres Detail des aus der Figur 3 bekannten Wickelträgers nebst gewendeltem Leiterstrang; die
- Figur 6:: einen Querschnitt durch einen Messwandler mit redundanten Wickelträgern und Leitersträngen.

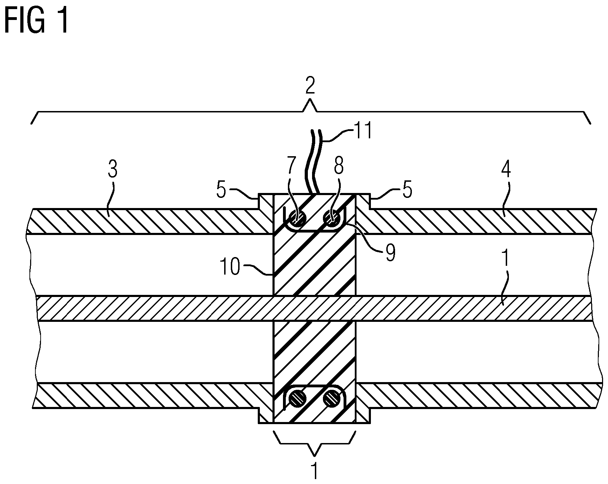

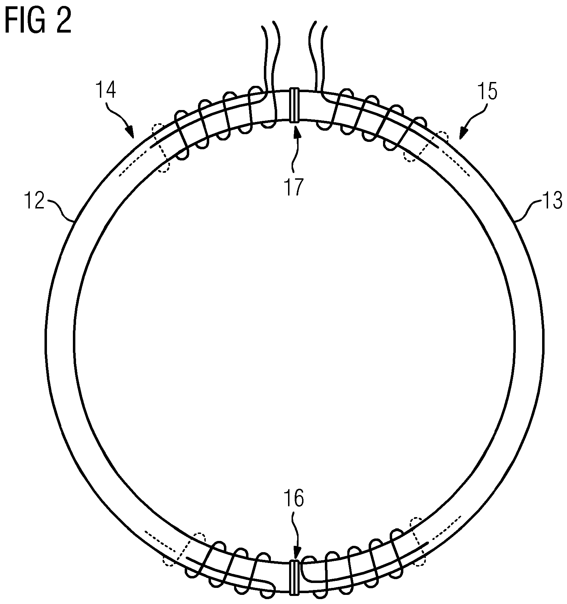

Die Figur 1 zeigt einen Schnitt durch eine Elektroenergieübertragungseinrichtung, welche einen Phasenleiter 1 aufweist. Der Phasenleiter 1 ist elektrisch isoliert im Inneren eines Kapselungsgehäuses 2 angeordnet. Das Kapselungsgehäuse 2 weist einen ersten Behälter 3 sowie einen zweiten Behälter 4 auf. Der erste sowie der zweite Behälter 3, 4 sind im Wesentlichen rohrförmig ausgebildet, wobei der Phasenleiter 1 zentrisch im Innern sowohl des ersten als auch des zweiten Behälters 3, 4 angeordnet ist. Die beiden Behälter 3, 4 sind über Flansche 5 miteinander verflanscht. Zwischen den Flanschen 5 des ersten sowie des zweiten Behälters 3, 4 ist ein Messwandler 6 angeordnet. Der Messwandler 6 weist eine erste Rogowskispule 7 sowie eine zweite Rogowskispule 8 auf. Die Rogowskispulen 7, 8 sind als im Wesentlichen ringförmig zu betrachten, wobei die beiden Rogowskispulen 7, 8 auf eine Ringelektrode 9 außenmantelseitig aufgesetzt sind. Die beiden Rogowskispulen 7, 8 sowie die Ringelektrode 9 sind in einem Isolierstoffkörper 10 eingeschlossen. Aus dem Isolierstoffkörper 10 sind Anschlussleitungen 11 (Wickelenden) herausgeführt, um die im Innern des Isolierstoffkörpers 10 befindlichen Rogowskispulen 7, 8 bzw. die Ringelektrode 9 kontaktieren zu können. Der Isolierstoffkörper 10 ist im Wesentlichen formkomplementär zum Querschnitt der Flansche 5 ausgebildet, so dass dieser fluiddicht in den Flanschverbund der Flansche 5 von erstem und zweitem Behälter 3, 4 eingefügt werden kann. Der Isolierstoffkörper 10 ist zentrisch fluiddicht von dem Phasenleiter 1 durchsetzt. Dadurch bildet der Isolierstoffkörper 10 bzw. der Messwandler 6 im Kapselungsgehäuse 2 eine fluiddichte Barriere aus. Einerseits ist ein fluiddichter Abschluss des stirnseitigen Endes an dem Flansch 5 des ersten Behälters 3 gegeben. Andererseits ist ein fluiddichter Abschluss des stirnseitigen Endes an dem Flansch 5 des zweiten Behälters 4 gegeben. So ist es möglich, das Innere des ersten Behälters 3 sowie das Innere des zweiten Behälters 4 jeweils mit einem elektrisch isolierenden Gas zu befüllen. Aufgrund des fluiddichten Verschlusses der Flansche 5 des Kapselungsgehäuses 2 ist ein Verflüchtigen des im Innern des Kapselungsgehäuses 2 befindlichen Gases bzw. ein Übertritt zwischen den Behältern 3, 4 nahezu verhindert. Das elektrisch isolierende Gas kann im Innern des Kapselungsgehäuses 2 auch unter Überdruck gesetzt werden, so dass die Isolationsfestigkeit desselben weiter erhöht wird. Der Aufbau der Rogowskispulen 7, 8 bzw. der Ringelektrode 9 nebst des Isolierstoffkörpers 10 wird im Folgenden anhand der Figuren 2 bis 5 beschrieben.

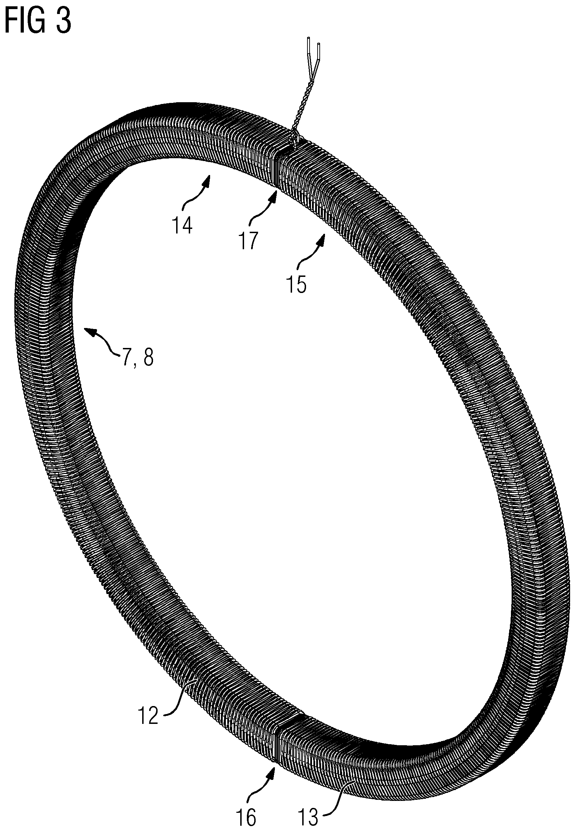

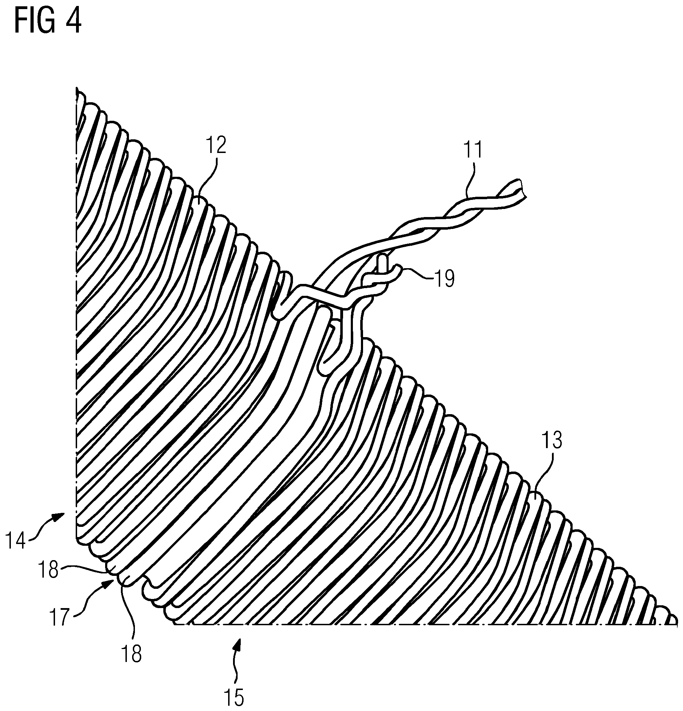

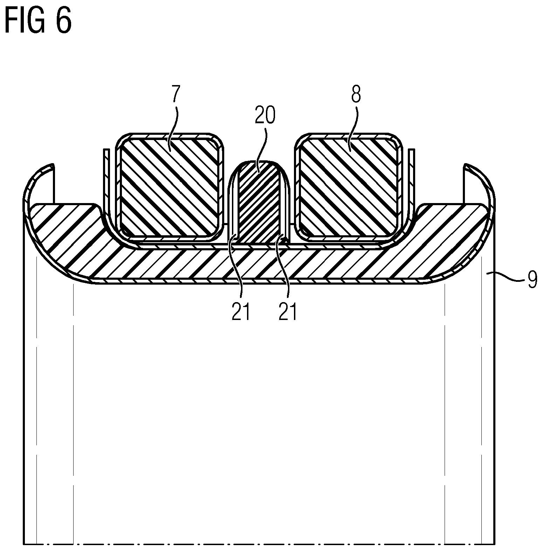

In der Figur 2 ist beispielhaft eine erste Ausführungsvariante einer Rogowskispule 7, 8 gezeigt. Die erste Ausführungsvariante einer Rogowskispule 7, 8 weist einen Wickelträger auf. Der Wickelträger ist vorliegend kreisförmig ausgebildet und aus einem ersten sowie einem zweiten Segment 12, 13 zusammengesetzt. Der Wickelträger bzw. die Segmente 12, 13 des Wickelträgers sind aus einem elektrisch isolierenden Material gebildet. Bevorzugt handelt es sich um ein homogenes elektrisch isolierendes Material wie beispielsweise ein Gießharz. Bevorzugt kann der Wickelträger aus dem gleichen Material gebildet sein wie der Isolierstoffkörper 10, welcher den Wickelträger nebst Rogowskispule 7, 8 in seinem Inneren einschließt (vgl. Figur 1 und Figur 6). Die beiden Segmente 12, 13 sind jeweils als Halbringe ausgebildet, wobei jeweils zwischen Endseiten der Segmente 12, 13 ein erster sowie ein zweiter Stoß 16, 17 angeordnet sind. Die Segmente 12, 13 weisen jeweils einen im Wesentlichen kreisförmigen Querschnitt auf, um welchen ein Leiterstrang gewendelt ist. Vorliegend ist der Leiterstrang aus einem ersten Teilstrang 14 sowie einem zweiten Teilstrang 15 zusammengesetzt. Die Segmente 12, 13 sind unter Bildung des ersten Stoßes 16 und des zweiten Stoßes 17 zu einem ringförmigen Wickelträger zusammengesetzt. Die Teilstränge 14, 15 sind ausgehend von dem zweiten Stoß 17 auf jeweils einem der Segmente 12, 13 gewickelt, wobei mit Erreichen des Endes des jeweiligen Segmentes 12, 13 am ersten Stoß 16 ein Wendepunkt in dem jeweiligen Teilstrang des Leiterstranges gebildet ist, woraufhin eine Richtungssinnänderung der Lagen der Wendelschlaufen erfolgt. Entsprechend ist zwischen der Helix der Hinwickelung zu dem Wendepunkt bezüglich der Rückwicklung der Helix von dem Wendepunkt des jeweiligen Teilstranges 14, 15 ein Überkreuzen der beiden Helices auf dem jeweiligen Segment 12, 13 vorgesehen. Diese Ausführung entspricht der Art der Ausführung der Teilstränge 14, 15 wie in den Figuren 3 bis 6 gezeigt. Als Alternative ist in der Figur 2 symbolisch dargestellt, dass jeder Teilstrang 14, 15 auf seinem Segment 12, 13 als Helix gewickelt ist, wobei ein wendelschlaufenfreies Rückführen des Teilstranges 14, 15 innerhalb der durch ihn gebildeten Helix erfolgt. Eine Rückführung kann derart erfolgen, dass zunächst von einem Ende des jeweiligen Segmentes 12, 13 ein Verlegen der Rückführung des Teilstranges 14, 15 auf der Oberfläche des Segmentes 12, 13 erfolgt und dass dann ein Winden der Helix um das jeweilige Segment 12, 13 zu dem freien Ende des Teilstranges (Wickelende) 14, 15 der Rückführung erfolgt. Entsprechend liegen die freien Enden des Teilstranges (Wickelenden) 14, 15 am gleichen Ende des Segmentes 12, 13. Entsprechend ist eine Rogowskispule 7, 8 mit Mittelanzapfung gebildet, welche am zweiten Stoß 17 befindlich ist. Am ersten Stoß 16 erfolgt eine Freilassung des Stoßes 16 selbst, so dass dieser nicht von einem Leiterstrang bzw. Teilstrang 14, 15 überbrückt ist. Entsprechend sind am zweiten Stoß 17 sowohl die Anfänge der Teilstränge 14, 15 als auch die Enden der Teilstränge 14, 15 befindlich. Bei einer derartigen Ausgestaltung ist es möglich, jedes der Segmente 12, 13 mit einer gleichartigen Art der Wicklung zu versehen, so dass im Umlauf um den Wickelträger kontinuierlich ein gleichmäßiger Windungsverlauf der Rogowskispule 7, 8 gegeben ist. Eine detaillierte Lage der Leiterstränge 14, 15 sowie der Freilassung bzw. Überbrückung des ersten Stoßes 16 bzw. des zweiten Stoßes 17 ist anhand des Ausführungsbeispiels in den Figuren 3 und 4 gezeigt. Dort ist für die Rückführung die Nutzung einer Helix vorgesehen.

Die Figur 3 zeigt eine ringförmige Rogowskispule 7, 8, welche einen rechteckigen Querschnitt aufweist. Das erste bzw. zweite Segment 12, 13 sind dabei bis auf die Ausführung des Querschnittes der Segmente 12, 13 gegenüber der Ausführungsvariante gemäß Figur 2 gleichartig. Die Segmente 12, 13 und damit auch der daraus gebildete Wickelträger weisen einen im Wesentlichen rechteckigen Querschnitt auf (vgl. auch Figur 6), so dass Wendelschlaufen mit rechteckigen Querschnitten auf den Segmenten 12, 13 gebildet sind. Auch hier ist vorgesehen, dass der zweite Stoß 17 zwischen den beiden Segmenten 12, 13 von einem elektrischen Leiter überbrückt ist. Vorliegend ist dies durch ein elektrisches Verbinden von ersten Enden der jeweiligen Teilstränge 14, 15 auf dem ersten bzw. zweiten Segment 12, 13 gebildet. In der Figur 3 ist jeder der Teilstränge 14, 15 jeweils mit einer linksgängigen Helix (weiß) sowie einer rechtsgängigen Helix (schwarz) ausgebildet, wobei die beiden Helices des jeweiligen Teilstranges 14, 15 innenmantelseitig und außenmantelseitig am Wickelträger im Wesentlichen parallel liegende Wendelschlaufen aufweisen. In axialer Richtung bezüglich der Ringachse des Wickelträgers ist ein Überkreuzen der einzelnen Windungen der Helices vorgesehen. Dabei ist an den Enden der Segmente 12, 13, an welchen der erste Stoß 16 angeordnet ist, ein Wendepunkt in dem jeweiligen Teilstrang 14, 15 gebildet, an welchem die rechtsgängige bzw. linksgängige Helix des jeweiligen Teilstranges 14, 15 ineinander übergehen/aneinander stoßen.

Aufgrund der Zuwendung der Enden der Segmente 12, 13, an welchen jeweils die Wendepunkte der Teilstränge 14, 15 angeordnet sind sowie die Zuwendung der Enden der Segmente 12, 13, an welchen jeweils die Leiterenden des jeweiligen Teilstranges 14, 15 enden, können gleichsinnig bzw. gleichartig bewickelte Segmente 12, 13 nebst darauf angeordneten Teilsträngen 14, 15 verwendet werden, weil dadurch ein gleichsinniger Verlauf über den Umfang des Wickelträgers hinweg erfolgt. Entsprechend ist jeweils das erste Segment 12 sowie das zweite Segment 13 mit dem ersten Teilstrang 14 sowie dem zweiten Teilstrang 15 gleichartig gewickelt. Dies weist den Vorteil auf, dass die Montage der Segmente 12, 13 vereinfacht möglich ist, da eindeutig ein Zuordnen der Enden der Segmente 12, 13, an welchen Anschlussleitungen befindlich bzw. die Wickelenden der Teilstränge 14, 15 angeordnet sind, vorgenommen wird und andererseits am ersten Stoß 16 ein Anstoßen der Enden der Segmente 12, 13 vorgenommen wird, an welchen Wendepunkte der Teilstränge 14, 15 angeordnet sind.

In der Figur 4 ist ein Detail des zweiten Stoßes 17 wie in der Figur 3 dargestellt, abgebildet. Zu erkennen sind die beiden Enden der Segmente 14, 15, welche den zweiten Stoß 17 ausbilden. Um ein Abrutschen bzw. Verlieren der aufgewendelten Teilstränge 14, 15 zu verhindern, sind die Enden der Segmente 12, 13 jeweils mit einem vorspringenden Anschlag 18 versehen. Die vorspringenden Anschläge 18 sind jeweils nach Art eines Bundes ausgebildet, welcher am Querschnitt des jeweiligen Wickelsegmentes 12, 13 endseitig umläuft. Die Höhe des Anschlages bzw. die Höhe des Bundes ist dabei derart gewählt, dass dieser etwa dem Durchmesser der Teilstränge 14, 15 entspricht. Somit ist es möglich, die Teilstränge 14, 15 nah an das Ende des Segmentes 12, 13 zu wickeln, und den Wendepunkt an dem jeweiligen vorspringenden Anschlag 18 der Segmente 12, 13 anschlagen zu lassen. Somit ist ein unerwünschtes Abrutschen der aufgewickelten Teilstränge 14, 15 von den Segmenten 12, 13 verhindert. Weiter ist in der Figur 4 erkennbar, dass außenmantelseitig bzw. innenmantelseitig am Wickelträger eine annähernd parallele Lage der Windungen des Leiterstranges vorliegt, wohingegen in axialer Richtung ein Überkreuzen der links- bzw. rechtsgängigen Helices auf dem jeweiligen Segment 12, 13 erfolgt. Anhand der Lage der beiden miteinander elektrisch kontaktierten Enden 19 der Teilstränge 14, 15 ist erkennbar, dass diese aus entgegengesetzten Richtungen, d. h. unter Beibehaltung des Wickelsinns der jeweiligen Helix aufeinander zulaufen. Das gleiche gilt auch für die beiden Anschlussleitungen 11, welche ebenfalls aus entgegengesetzten Richtungen, d. h. unter Beibehaltung des Wickelsinns der jeweiligen Helix nach außen geführt sind. Die Wickelenden 19, welche miteinander elektrisch leitend kontaktiert sind, brücken dabei den ersten Stoß 16 und queren diesen. Analoges gilt auch für die Anschlussleitungen 11.

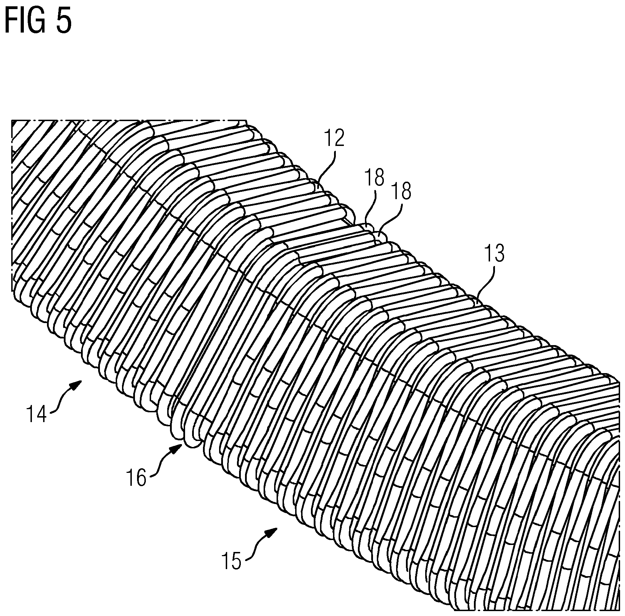

In der Figur 5 ist der erste Stoß 16 des in Figur 3 gezeigten Wickelträgers abgebildet. Dort ist der erste Stoß 16 gezeigt, welcher zwischen den einander zugewandten Enden der Segmente 12, 13 ausgebildet ist. Auch hier ist die Verwendung von vorspringenden Anschlägen 18 in Form von umlaufenden Bünden vorgesehen, um die im Bereich des zweiten Stoßes beiderseits befindlichen Wendepunkte zwischen den links- bzw. rechtsgängigen Helices der Teilstränge 14, 15 zu begrenzen. Die linksgängigen Helices sowie die rechtsgängigen Helices sind dabei derart ausgebildet, dass innenmantelseitig bzw. außenmantelseitig jeweils wechselweise Leiterschlaufen einer rechtsgängigen bzw. linksgängigen Helix angeordnet sind. Ein Überkreuzen zum Ausgleichen der Lagen erfolgt in axialer Richtung (stirnseitig) bezüglich der Innenmantelfläche bzw. der Außenmantelfläche des Wickelträgers.

Die Figur 6 zeigt eine Anordnung eines Wickelträgers nebst gewendeltem Leiterstrang auf einer Ringelektrode 9 im Ausschnitt. Die Ringelektrode 9 ist im Wesentlichen der Darstellung der Figur 1 entsprechend, d. h. die Ringelektrode 9 ist im Wesentlichen hohlzylindrisch ausgebildet, wobei außenmantelseitig an der Ringelektrode 9 ein Felgenbett gebildet ist. In das Felgenbett sind zwei gleichartig aufgebaute Wickelkörper nebst Leitersträngen eingesetzt. Hier erweist sich die Ausbildung der Rogowskispule 7, 8 mit Mittelanzapfung vorteilhaft, um einen sich öffnenden Wickelträger auf die Ringelektrode 9 aufzusetzen. Im Felgenbett der Ringelektrode 9 ist ein Füllkörper angeordnet, um eine zentrische Positionierung der beiden Rogowskispulen 7, 8 vorzunehmen. Weiterhin ist zwischen den Rogowskispulen 7, 8 ein Abstandhalter 20 angeordnet. Sowohl der Abstandhalter 20 als auch der Füllkörper im Boden des Felgenbettes der Ringelektrode 9 als auch der noch zu erstellende Isolierstoffkörper 10 sind vorzugsweise aus dem gleichen Isoliermaterial gebildet. Der Abstandhalter 20 beabstandet die Rogowskispulen 7, 8 voneinander und weist Ausnehmungen 21 auf, welche im Wesentlichen in radialer Richtung ausgerichtet sind. Somit besteht die Möglichkeit, bei einem Verguss der Rogowskispulen 7, 8 zu einem Isolierstoffkörper 10 den zwischenzeitlich flüssigen Isolierstoff auch in Zwickelräume bzw. Innenmantelseiten der Rogowskispulen 7, 8 zu leiten und einen bevorzugt einschlussfreien Verguss mit einem elektrisch isolierenden flüssigen Materials vorzunehmen, so dass ein blockartiger Isolierstoffkörper 10 gebildet ist.

Bevorzugt erfolgt ein Verguss in einer Gussform zu einem im Wesentlichen zylindrischen Isolierstoffkörper 10.

## Patentansprüche

1. Anordnung aufweisend einen gewendelten Leiterstrang, welcher von einem Wickelträger getragen ist und der Wickelträger ein Ring aus mehreren aneinander stoßenden Segmenten (12, 13) ist, wobei an zumindest einem ersten Stoß (16) der gewendelte Leiterstrang beiderseits des Stoßes (16) unter Freilassung desselben endet und an einem zweiten Stoß (17) der Leiterstrang über den zweiten Stoß (17) hinweg verläuft,
**dadurch gekennzeichnet, dass**
der Wickelträger nebst Leiterstrang in einem Isolierkörper (10) vergossen ist.

2. Anordnung nach Anspruch 1,
**dadurch gekennzeichnet, dass**
der gewendelte Leiterstrang aus mehreren Teilsträngen (14, 15) zusammengesetzt ist.

3. Anordnung nach Anspruch 1 oder 2,
**dadurch gekennzeichnet, dass** zumindest ein Segment (12, 13) von aneinander stoßenden Segmenten (12, 13) einen radial vorspringenden Anschlag (18) aufweist, welcher ein endseitiges Abrutschen des Leiterstranges verhindert.

4. Anordnung nach einem der Patentansprüche 1 bis 3,
**dadurch gekennzeichnet, dass** der Leiterstrang, insbesondere ein Teilstrang auf ein Segment gewickelt ist, wobei umgriffen von der gebildeten Helix eine Rückführung eines Winkelendes des Leiterstranges bzw. Winkelendes des Teilstranges, innerhalb der Helix erfolgt.

5. Anordnung nach einem der Ansprüche 1 bis 4,
**dadurch gekennzeichnet, dass** der Leiterstrang, insbesondere ein Teilstrang derart auf ein Segment (12, 13) gewickelt ist, dass zunächst eine linksgängige Helix gewickelt und mit Erreichen eines Endes eines Segmentes eine rechtsgängige Helix in zwischen den Helixschlaufen der linksgängigen Helix befindliche Freiräume oder umgekehrt unter jeweiligem Kreuzen der beiden Helices eingelegt ist.

6. Anordnung nach einem der Ansprüche 1 bis 5,
**dadurch gekennzeichnet, dass** der Wickelträger einen Wärmeausdehnungskoeffizienten aufweist, der kleiner, gleich dem Wärmeausdehnungskoeffizienten des Isolierkörpers (10) ist.

7. Anordnung nach einem der Ansprüche 1 bis 6,
**dadurch gekennzeichnet, dass** jedes der Segmente (12, 13) gleichartig aufgebaut ist und jeweils einen gleichartigen Teilstrang (14, 15) des Leiterstranges trägt.

8. Anordnung nach einem der Ansprüche 1 bis 7,
**dadurch gekennzeichnet, dass** jeweils ein endseitiges Ende zweier Teilstränge (14, 15) an aneinanderstoßenden Segmenten (12, 13) miteinander kontaktiert sind, während die jeweils anderen Enden der Teilstränge (14, 15) einem Abgriff eines Messsignals insbesondere am selben Stoß (17) dienen.

9. Anordnung nach einem der Ansprüche 1 bis 8,
**dadurch gekennzeichnet, dass** zwei ringförmige Wickelträger koaxial zueinander angeordnet sind und vor einem Verguss in einem Isolierkörper (10) ein Abstandhalter (20) zwischen den Wickelkörpern angeordnet ist, wobei der Abstandhalter (20) im Wesentlichen radial ausgerichtete Kanäle (21) aufweist.

10. Anordnung nach einem der Ansprüche 1 bis 9,
**dadurch gekennzeichnet, dass** die Anordnung einen Messwandler in einer druckfluidisolierten Elektroenergieübertragungseinrichtung bildet.

## Claims

1. Arrangement having a spiraled conductor strand, which is supported by a winding support and the winding support is a ring comprising a plurality of mutually abutting segments (12, 13), wherein, at at least one first abutment (16), the spiraled conductor strand ends on both sides of the abutment (16) whilst leaving the abutment free, and, at a second abutment (17), the conductor strand runs beyond the second abutment (17),
**characterized in that**
the winding support as well as the conductor strand is potted in an insulating body (10).

2. Arrangement according to Claim 1,
**characterized in that**
the spiraled conductor strand is assembled from a plurality of strand elements (14, 15).

3. Arrangement according to Claim 1 or 2,
**characterized in that**
at least one segment (12, 13) of mutually abutting segments (12, 13) has a radially protruding stop (18), which prevents the conductor strand from sliding off at the end.

4. Arrangement according to one of Patent Claims 1 to 3,
**characterized in that**
the conductor strand, in particular a strand element, has been wound onto a segment, wherein, surrounded by the helix formed, a winding end of the conductor strand or winding end of the strand element is passed back within the helix.

5. Arrangement according to one of Claims 1 to 4,
**characterized in that**
the conductor strand, in particular a strand element, has been wound onto a segment (12, 13) in such a way that, first, a left-handed helix has been wound and, when an end of a segment has been reached, a right-handed helix has been inserted into free spaces located between the helix loops of the left-handed helix, or vice versa, with respective crossing-over of the two helices.

6. Arrangement according to one of Claims 1 to 5,
**characterized in that**
the winding support has a coefficient of thermal expansion which is less than or equal to the coefficient of thermal expansion of the insulating body (10).

7. Arrangement according to one of Claims 1 to 6,
**characterized in that**
each of the segments (12, 13) is constructed similarly and supports in each case a similar strand element (14, 15) of the conductor strand.

8. Arrangement according to one of Claims 1 to 7,
**characterized in that**
in each case one end-side end of two strand elements (14, 15) have been brought into contact with one another at mutually abutting segments (12, 13), while the respective other ends of the strand elements (14, 15) serve as a tap for a measurement signal, in particular at the same abutment (17).

9. Arrangement according to one of Claims 1 to 8,
**characterized in that**
two annular winding supports have been arranged coaxially with respect to one another, and, prior to potting in an insulating body (10), a spacer (20) has been arranged between the winding bodies, wherein the spacer (20) has substantially radially aligned channels (21).

10. Arrangement according to one of Claims 1 to 9,
**characterized in that**
the arrangement forms a measuring transformer in a pressurized-fluid-insulated electrical energy transmission device.

## Revendications

1. Dispositif comportant une corde conductrice enroulée en spirale, qui est portée par un support d'enroulement et le support d'enroulement est un anneau composé de plusieurs segments (12, 13) aboutés les uns aux autres, dans lequel, en au moins un premier bout (16), la corde conductrice enroulée en spirale se termine de deux côtés du bout (16) en le laissant libre et, en un autre deuxième bout (17), la corde conductrice s'étend par-dessus le deuxième bout (17), **caractérisé en ce que** le support d'enroulement est coulé, outre la corde conductrice, dans un corps (10) isolant.

2. Dispositif suivant la revendication 1,
**caractérisé en ce que** la corde conductrice enroulée en spirale est composée de plusieurs cordes (14, 15) partielles.

3. Dispositif suivant la revendication 1 ou 2,
**caractérisé en ce qu'**au moins un segment (12, 13) de segments (12, 13) aboutés les uns aux autres a une saillie (18) faisant saillie radialement, qui empêche un glissement du côté de l'extrémité de la corde conductrice.

4. Dispositif suivant l'une des revendications 1 à 3,
**caractérisé en ce que** la corde conductrice, en particulier une corde partielle, est enroulée sur un segment, dans lequel enserrée par l'hélice formée, un retour d'une extrémité angulaire de la corde conductrice ou d'une extrémité angulaire de la corde partielle s'effectue à l'intérieur à l'hélice.

5. Dispositif suivant l'une des revendications 1 à 4,
**caractérisé en ce que** la corde conductrice, en particulier une corde partielle, est enroulée sur un segment (12, 13) de manière à enrouler d'abord une hélice à pas à gauche et, lorsqu'une extrémité d'un segment est atteinte, une hélice à pas à droite est insérée, avec croisement respectif des deux hélices, dans des espaces libres se trouvant entre les boucles hélicoïdales de l'hélice à pas à gauche ou inversement.

6. Dispositif suivant l'une des revendications 1 à 5,
**caractérisé en ce que** le support d'enroulement a un coefficient de dilatation thermique, qui est inférieur ou égal au coefficient de dilatation thermique du corps (10) isolant.

7. Dispositif suivant l'une des revendications 1 à 6,
**caractérisé en ce que** chacun des segments (12, 13) est constitué de la même façon et porte respectivement une corde (14, 15) partielle de même type de la corde conductrice.

8. Dispositif suivant l'une des revendications 1 à 7,
**caractérisé en ce que** respectivement une extrémité du côté de l'extrémité de deux cordes (14, 15) partielles de segments (12, 13) aboutés les uns aux autres sont mises en contact l'une avec l'autre, tandis que respectivement les autres extrémités des cordes (14, 15) partielles servent à un prélèvement d'un signal de mesure, en particulier au même bout (17).

9. Dispositif suivant l'une des revendications 1 à 8,
**caractérisé en ce que** deux supports d'enroulement annulaires sont disposés coaxialement l'un à l'autre et, avant une coulée en un corps (10) isolant, une entretoise (20) est disposée entre les corps d'enroulement, l'entretoise (20) ayant des canaux (21) dirigés sensiblement radialement.

10. Dispositif suivant l'une des revendications 1 à 9,
**caractérisé en ce que** le dispositif forme un transducteur de mesure dans un dispositif de transport d'énergie électrique isolé par du fluide sous pression.
